# EUROPEAN PATENT APPLICATION

(11) **EP 3 689 613 A1**
(43) Date of publication of application: **05.08.2020**
(21) Application number: 18860279.1
(22) Date of filing: 03.07.2018
(51) Int. Cl.: B41J 2/14, B05C 5/00, B05C 11/10, B41J 2/045, F04B 9/10

(54) **LIQUID AGENT APPLICATION DEVICE**

(30) Priority: 28.09.2017 JP 2017188842
(71) Applicant: Nidec Corporation, Kyoto-shi, Kyoto 601-8205 (JP); National University Corporation Saitama University, Saitama City, Saitama 338-8570 (JP)
(72) Inventor: MAEDA, Kenji, Kyoto-shi Kyoto 601-8205 (JP); NAKATANI, Masaji, Kyoto-shi Kyoto 601-8205 (JP); TAKASAKI, Masaya, Saitama-shi Saitama 338-8570 (JP)
(74) Representative: Viering, Jentschura & Partner mbB Patent- und Rechtsanwälte
(86) International application number: PCT/JP2018/025146
(87) International publication number: WO 2019/064779

(57) **Abstract**

[Object] A liquid agent application device capable of adjusting the displacement amount of a diaphragm is provided. [Solution] The liquid agent application device 10 includes a diaphragm 12 that changes the internal volume of a liquid agent reservoir 11, and a drive unit 13 located on the diaphragm 12. The drive unit 13 includes a driving piezoelectric element 20 that vibrates in response to application of a drive voltage signal, and a horn 21 that vibrates together with the driving piezoelectric element 20.

## Description

### TECHNICAL FIELD

The present invention relates to a liquid agent application device.

### BACKGROUND ART

Since the piezoelectric element that converts energy from electrical energy to mechanical energy by the piezoelectric effect are excellent in responsiveness, it is used in a liquid agent application device that discharges a liquid agent onto the surface of an object in wide fields such as semiconductor, printing, chemicals, etc.

The liquid agent application device includes a liquid agent reservoir having a discharge port, a diaphragm for changing the volume in the liquid agent reservoir, and a piezoelectric element that pressurization vibrates the diaphragm (see, for example, Patent Literature 1).

### CITATION LIST

### PATENT LITERATURE

Patent Literature 1: JP 2007-160701 A

### SUMMARY OF INVENTION

### TECHNICAL PROBLEMS

Here, since the ease of discharging the liquid agent from the discharge port varies depending on the viscosity of the liquid agent, there is a desire to appropriately adjust the displacement amount of the diaphragm.

However, since the amount of expansion and contraction of the piezoelectric element is very small, and the displacement amount of the diaphragm is small, adjusting the displacement amount of the diaphragm only by the piezoelectric element is limited.

The present invention has been made in view of the above situation, an object of the present invention is to provide a liquid agent application device capable of adjusting a displacement amount of a diaphragm.

### SOLUTION TO PROBLEMS

The liquid agent application device according to an aspect of the present invention includes a liquid agent reservoir, a diaphragm, and a drive unit. The liquid agent reservoir has a liquid agent discharge port. The diaphragm changes the internal volume of the liquid agent reservoir. The drive unit is located on the diaphragm. The drive unit includes a driving piezoelectric element that vibrates in response to application of a drive voltage signal and a horn that vibrates together with the driving piezoelectric element.

### ADVANTAGEOUS EFFECTS OF INVENTION

According to an aspect of the present invention, it is possible to provide a liquid agent application device that can adjust the amount of displacement of the diaphragm.

### BRIEF DESCRIPTION OF DRAWINGS

FIG. 1 is a schematic diagram showing a configuration of a liquid agent application device according to a first embodiment.
FIG. 2 is a schematic diagram showing a configuration of a liquid agent application device according to a second embodiment.
FIG. 3 is a schematic diagram showing a configuration of a liquid agent application device according to a third embodiment.
FIG. 4 is a schematic diagram showing a configuration of a liquid agent application device according to a fourth embodiment.
FIG. 5 is a schematic diagram for explaining a method of fixing a driving piezoelectric element with a fastener.

### DESCRIPTION OF EMBODIMENTS

Hereinafter, referring to the drawings, a liquid agent application device according to an embodiment of the present invention will be described. Note that the scope of the present invention is not limited to the embodiments described below, but includes any modification thereof within the scope of the technical idea of the present invention. Further, in the following drawings, to easily understand each component, a scale, the number, etc. of each structure may be different from those of actual structures.

In this specification, "connection" means a state in which two members are fixed or coupled to each other. Thus, when two members are connected, they always operate together. "Contact" means a state where the two members are not fixed or connected to each other although the two members are in direct contact. When two members are in contact with each other, there is a case where both operate together and a case where both do not operate together. In the present specification, the "end portion" of each member means an end portion in the expansion/contraction direction of the piezoelectric element.

### <First Embodiment>

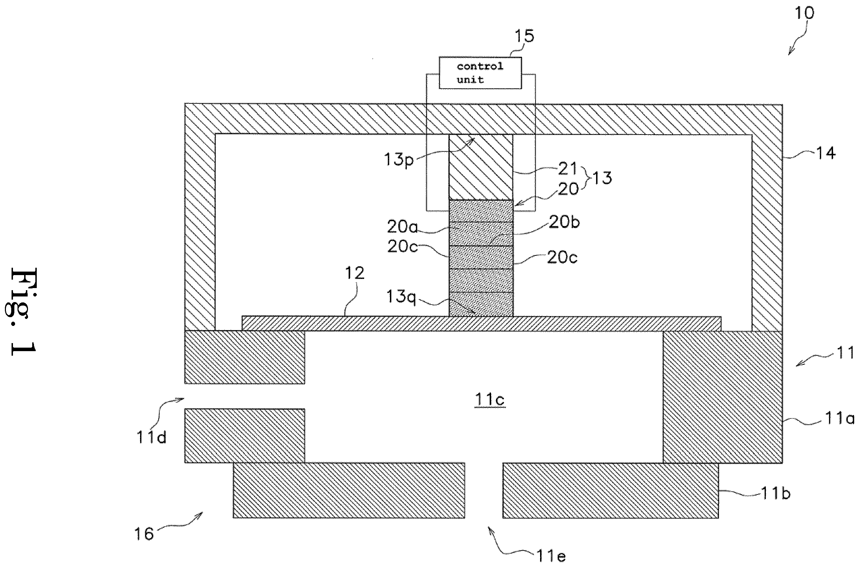

FIG. 1 is a schematic diagram showing the configuration of a liquid agent application device 10 according to the first embodiment.

The liquid agent application device 10 includes a liquid agent reservoir 11, a diaphragm 12, a drive unit 13, a fixing member 14, and a control unit 15. The liquid agent reservoir 11, the diaphragm 12, the drive unit 13, and the fixing member 14 constitute a head 16.

### (1) Liquid agent reservoir 11

The liquid agent reservoir 11 includes a housing 11a and a nozzle 11b.

The housing 11a is formed in a hollow shape. In the present embodiment, the housing 11a is formed in a tubular shape, but is not limited thereto. The housing 11a can be made of, for example, an alloy material, a ceramic material, and a synthetic resin material, and the design is made to enhance the rigidity so that it is prevented from being deformed by the application of a pressing force by the drive unit 13 described later. The rigidity of the housing 11a can be appropriately adjusted by optimizing the thickness according to the constituent material. Also, when manufacturing the housing 11a by molding and casting, the rigidity of the housing 11a can be effectively improved by providing ribs on the outer peripheral face.

A pressure chamber 11c is formed inside the housing 11a. A liquid agent is stored in the pressure chamber 11c. Examples of the liquid agent include solder, thermosetting resin, ink, coating liquid for forming functional thin films (oriented film, resist, color filter, organic electroluminescence, etc.), but are not limited to this.

A liquid agent supply port 11d is formed in the side wall of the housing 11a. A liquid agent supplied from a liquid agent supply device (not shown) passes through the liquid agent supply port 11d and is replenished into the pressure chamber 11c.

The nozzle 11b is formed in a plate shape. The nozzle 11b is disposed so as to close one end opening of the housing 11a. A discharge port 11e is formed in the nozzle 11b. The liquid agent in the pressure chamber 11c is discharged as a droplet from the discharge port 11e.

### (2) Diaphragm 12

The diaphragm 12 is disposed so as to close the other end opening of the housing 11a. The diaphragm 12 vibrates elastically when a pressurization vibration is applied from the drive unit 13 described later. Accordingly, the diaphragm 12 changes the volume of the pressure chamber 11c formed in the liquid agent reservoir 11.

When the diaphragm 12 curves convexly toward the inside of the pressure chamber 11c, the volume of the pressure chamber 11c decreases. As a result, the liquid agent is discharged from the discharge port 11e. Thereafter, when the diaphragm 12 returns to a steady state by its own elasticity, the volume of the pressure chamber 11c also returns to the original state. At this time, the liquid agent is replenished to the pressure chamber 11c from the liquid agent supply port 11d.

Although the constituent material of the diaphragm 12 is not particularly limited, for example, an alloy material, a ceramic material, a synthetic resin material, or the like can be used.

### (3) Drive unit 13

The drive unit 13 is a member for expansion and contraction driving the diaphragm 12. The drive unit 13 is located on the diaphragm 12. The drive unit 13 is disposed between the diaphragm 12 and the fixing member 14. The drive unit 13 is sandwiched between the diaphragm 12 and the fixing member 14.

A first end portion 13p, of the drive unit 13, opposite to the diaphragm 12 is connected to the fixing member 14. That is, the first end portion 13p of the drive unit 13 is fixed to the fixing member 14. Accordingly, the first end portion 13p of the drive unit 13 is a fixed end portion. The first end portion 13p of the drive unit 13 can be connected to the fixing member 14 via an adhesive such as an epoxy resin, for example. In the present embodiment, the first end portion 13p of the drive unit 13 is part of a horn 21 described later.

A second end portion 13q, of the drive unit 13, toward the diaphragm 12 is in contact with the diaphragm 12. That is, the second end portion 13q of the drive unit 13 is not fixed to the diaphragm 12. In the present embodiment, the second end portion 13q of the drive unit 13 is part of a driving piezoelectric element 20 described later.

The drive unit 13 includes the driving piezoelectric element 20 and the horn 21.

The driving piezoelectric element 20 is located on the diaphragm 12. The driving piezoelectric element 20 is disposed between the diaphragm 12 and the horn 21. The driving piezoelectric element 20 is sandwiched between the diaphragm 12 and the horn 21.

The driving piezoelectric element 20 is connected to the horn 21. The driving piezoelectric element 20 is connected to the horn 21 via an adhesive such as an epoxy resin.

The driving piezoelectric element 20 is in contact with the diaphragm 12. That is, the driving piezoelectric element 20 is not connected to the diaphragm 12. However, the driving piezoelectric element 20 may be connected to the diaphragm 12.

The driving piezoelectric element 20 includes a plurality of piezoelectric bodies 20a, a plurality of internal electrodes 20b, and a pair of side surface electrodes 20c and 20c. The piezoelectric bodies 20a and the internal electrodes 20b are alternately stacked. Each of the piezoelectric bodies 20a is made of, for example, piezoelectric ceramic such as lead zirconate titanate (PZT). Each of the internal electrodes 20b is electrically connected to one of the pair of side surface electrodes 20c and 20c. That is, the internal electrode 20b electrically connected to one side surface electrode 20c is electrically insulated from the other side surface electrode 20c. Such a structure is generally referred to as a partial electrode structure. However, the driving piezoelectric element 20 only needs to include at least one piezoelectric body and a pair of electrodes, and various known piezoelectric elements can be used as the driving piezoelectric element 20.

The driving piezoelectric element 20 vibrates according to a drive voltage signal (that is, a drive pulse) applied from the control unit 15 described later. In particular, when a drive voltage signal is applied from the control unit 15 to the pair of side surface electrodes 20c and 20c, each of the piezoelectric bodies 20a expands and contracts. Along with the expansion and contraction of each of the piezoelectric bodies 20a, a pressurization vibration is applied to the diaphragm 12.

The horn 21 is located on the driving piezoelectric element 20. The horn 21 is disposed between the fixing member 14 and the driving piezoelectric element 20. The horn 21 is sandwiched between the fixing member 14 and the driving piezoelectric element 20. In the present embodiment, the horn 21 is a tubular metal rod.

The horn 21 is connected to the fixing member 14 and the driving piezoelectric element 20. The horn 21 can be connected to the fixing member 14 via an adhesive such as an epoxy resin.

The horn 21 is a vibrating body which vibrates with the driving piezoelectric element 20 to increase the amount of displacement of the diaphragm 12 due to expansion and contraction of the driving piezoelectric element 20. The natural vibration frequency F1 of the horn 21 is equal to or lower than the drive critical frequency F2 of the driving piezoelectric element 20.

The natural vibration frequency F1 of the horn 21 is a frequency at which the horn 21 performs free vibration. The natural vibration frequency F1 of the horn 21 is a frequency specific to the horn 21. The natural vibration frequency F1 of the horn 21 is determined by the shape, material, mass, and the like of the horn 21. Accordingly, the shape, material, mass and the like of the horn 21 are not particularly limited, and it is sufficient that the natural vibration frequency F1 is set to a desired value.

The drive critical frequency F2 of the driving piezoelectric element 20 is the maximum value of the critical frequency at which the driving piezoelectric element 20 can be driven with a stable amplitude. The drive critical frequency F2 of the driving piezoelectric element 20 is a frequency specific to the driving piezoelectric element 20. The drive critical frequency F2 of the driving piezoelectric element 20 is determined by the configuration of the driving piezoelectric element 20. The frequency (hereinafter referred to as "drive voltage signal frequency") F3 of the drive voltage signal applied to the driving piezoelectric element 20 is set to the drive critical frequency F2 or less.

Here, when the natural vibration frequency F1 of the horn 21 is equal to or lower than the drive critical frequency F2 of the driving piezoelectric element 20, and the natural vibration frequency F1 and the drive voltage signal frequency F3 are in a multiple relationship, the horn 21 resonates with the driving piezoelectric element 20. In this case, the closer the natural vibration frequency F1 of the horn 21 is to the drive voltage signal frequency F3, the higher the degree of resonance between the horn 21 and the driving piezoelectric element 20, and the greater the amplitude between the horn 21 and the driving piezoelectric element 20. When the natural vibration frequency F1 of the horn 21 is the same as the drive voltage signal frequency F3, the degree of resonance between the horn 21 and the driving piezoelectric element 20 is maximized, and the amplitude between the horn 21 and the driving piezoelectric element 20 is also maximized.

Therefore, when the frequency difference between the natural vibration frequency F1 of the horn 21 and the drive voltage signal frequency F3 is reduced, the amplitude between the horn 21 and the driving piezoelectric element 20 increases, so that the amount of displacement of the diaphragm 12 by the driving piezoelectric element 20 can be increased. As a result, since a sufficient amount of displacement can be secured even when the voltage applied to the driving piezoelectric element 20 is reduced, the power consumption (including the amount output as displacement force and the amount consumed as heat) for the driving piezoelectric element 20 can be reduced.

On the other hand, since the amplitude between the horn 21 and the driving piezoelectric element 20 can be reduced when the frequency difference between the natural vibration frequency F1 of the horn 21 and the drive voltage signal frequency F3 is increased, the amount of displacement of the diaphragm 12 can be reduced. In this way, the amount of displacement of the diaphragm 12 can be adjusted as appropriate by controlling the degree of resonance between the horn 21 and the driving piezoelectric element 20.

### (4) Fixing member 14

The fixing member 14 is a member that fixes the first end portion 13p of the drive unit 13. The fixing member 14 is located on the liquid agent reservoir 11. However, the fixing member 14 only needs to fix the first end portion 13p of the drive unit 13, and may be separated from the liquid agent reservoir 11. Further, the shape of the fixing member 14 is not limited to the shape shown in FIG. 1, and can be appropriately changed in consideration of the positional relationship with the peripheral members.

### (5) Control unit 15

The control unit 15 is realized by a power amplifier composed of a microprocessor such as a central processing unit (CPU) and a digital signal processor (DSP), or an arithmetic device such as an application specific integrated circuit (ASIC), a power metal-oxide-semiconductor field-effect transistor (MOSFET) and the like.

The control unit 15 generates a drive voltage signal for driving the driving piezoelectric element 20. The control unit 15 sends the generated drive voltage signal to the power amplifier to amplify the power, and applies the power to each of the pair of side surface electrodes 20c and 20c of the driving piezoelectric element 20 to vibrate the driving piezoelectric element 20.

The control unit 15 sets the drive voltage signal frequency F3 of the drive voltage signal to be equal to or lower than the drive critical frequency F2 of the driving piezoelectric element 20, and sets the natural vibration frequency F1 of the horn 21 and the drive voltage signal frequency F3 to have a multiple relationship. As mentioned above, the amount of displacement of the diaphragm 12 can be changed as appropriate by controlling the frequency difference between the natural vibration frequency F1 of the horn 21 and the drive voltage signal frequency F3.

The control unit 15 preferably adjusts the drive voltage signal frequency F3 of the drive voltage signal in accordance with the displacement of the driving piezoelectric element 20. For this adjustment, a method of performing control so that the peak value is constant from the current and voltage in the waveform of the drive voltage signal or a method of performing control so that the phase difference between the current and voltage in the waveform of the drive voltage signal is constant can be used. In particular, in control by the phase difference, the feedback is performed so that the phase difference at the resonance frequency which is obtained in advance is set as the control target value, and the phase difference detected in actual driving matches the control target value. As a result, since the drive voltage signal frequency F3 can be matched with the natural vibration frequency F1, the driving piezoelectric element 20 can be vibrated more efficiently.

### <Second Embodiment>

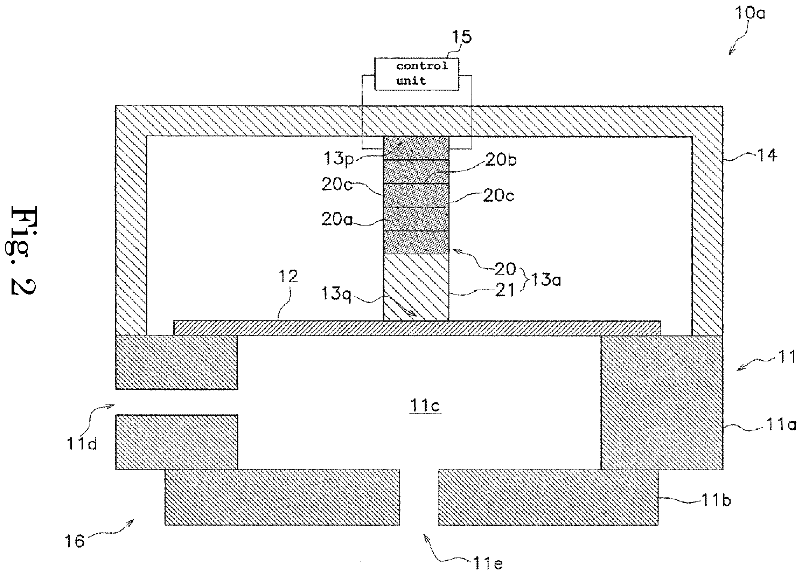

FIG. 2 is a schematic diagram showing a configuration of a liquid agent application device 10a according to the second embodiment. The difference between the liquid agent application device 10 according to the first embodiment and the liquid agent application device 10a according to the second embodiment is that the driving piezoelectric element 20 and the horn 21 are arranged in reverse. Therefore, the difference will be mainly described below.

A drive unit 13a is located on the diaphragm 12. The drive unit 13a is disposed between the diaphragm 12 and the fixing member 14. The first end portion 13p of the drive unit 13a is connected to the fixing member 14. The second end portion 13q of the drive unit 13a is in contact with the diaphragm 12. In this embodiment, the first end portion 13p of the drive unit 13a is part of the driving piezoelectric element 20, the second end portion 13q of the drive unit 13a is part of the horn 21.

The drive unit 13 includes the driving piezoelectric element 20 and the horn 21.

The driving piezoelectric element 20 is located on the horn 21. The driving piezoelectric element 20 is disposed between the fixing member 14 and the horn 21. The driving piezoelectric element 20 is sandwiched between the fixing member 14 and the horn 21. The driving piezoelectric element 20 is connected to the fixing member 14 and the horn 21.

The horn 21 is located on the diaphragm 12. The horn 21 is disposed between the diaphragm 12 and the driving piezoelectric element 20. The horn 21 is sandwiched between the diaphragm 12 and the driving piezoelectric element 20.

The horn 21 is connected to the driving piezoelectric element 20. The horn 21 is in contact with the diaphragm 12. However, the horn 21 may be connected to the diaphragm 12.

As above, even when the horn 21 and the driving piezoelectric element 20 are sequentially arranged from the diaphragm 12 side, the displacement amount of the diaphragm 12 by the driving piezoelectric element 20 can be appropriately changed by the horn 21 by adjusting the frequency difference between the natural vibration frequency F1 of the horn 21 and the drive voltage signal frequency F3 as described in the first embodiment.

### <Third Embodiment>

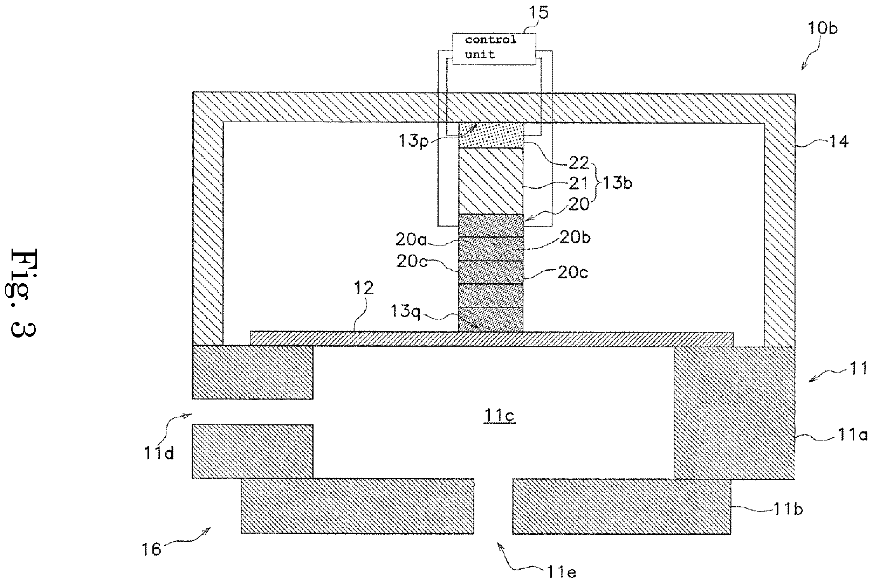

FIG. 3 is a schematic diagram showing the configuration of a liquid agent application device 10b according to the third embodiment. The difference between the liquid agent application device 10 according to the first embodiment and the liquid agent application device 10b according to the third embodiment is that the drive unit 13b includes an oscillating piezoelectric element 22. Therefore, the difference will be mainly described below.

The drive unit 13b is located on the diaphragm 12. The drive unit 13b is disposed between the diaphragm 12 and the fixing member 14. The first end portion 13p of the drive unit 13b is connected to the fixing member 14. The second end portion 13q of the drive unit 13b is in contact with the diaphragm 12. In this embodiment, the first end portion 13p of the drive unit 13b is part of the oscillating piezoelectric element 22 described later, and the second end portion 13q of the drive unit 13a is part of the driving piezoelectric element 20.

The drive unit 13b includes the driving piezoelectric element 20, the horn 21, and the oscillating piezoelectric element 22.

The configuration of the driving piezoelectric element 20 and the horn 21 is as described in the first embodiment. Therefore, also in this embodiment, the amount of displacement of the diaphragm 12 can be changed as appropriate by controlling the frequency difference between the natural vibration frequency F1 of the horn 21 and the drive voltage signal frequency F3.

The oscillating piezoelectric element 22 is located on the horn 21. The oscillating piezoelectric element 22 is disposed between the fixing member 14 and the horn 21. The oscillating piezoelectric element 22 is sandwiched between the fixing member 14 and the horn 21.

The oscillating piezoelectric element 22 is connected to the horn 21. The oscillating piezoelectric element 22 is connected to the horn 21 via an adhesive such as an epoxy resin.

The oscillating piezoelectric element 22 is connected to the fixing member 14. The oscillating piezoelectric element 22 can be connected to the fixing member 14 via an adhesive such as an epoxy resin.

The oscillating piezoelectric element 22 includes at least one piezoelectric body and a pair of electrodes. Examples of the oscillating piezoelectric element 22 can include various known piezoelectric elements. The oscillating piezoelectric element 22 vibrates according to the high-frequency signal applied from the control unit 15. The high-frequency signal applied to the oscillating piezoelectric element 22 is a signal having a higher frequency than that of the drive voltage signal applied to the driving piezoelectric element 20. The amplitude (potential difference) of the high-frequency signal is preferably smaller than the amplitude (potential difference) of the drive voltage signal.

The oscillating piezoelectric element 22 to which the high-frequency signal is applied applies a minute pressurization vibration to the diaphragm 12 such that the liquid agent is not discharged from the discharge port 11e. As a result, while improving the fluidity of the liquid agent stored in the liquid agent reservoir 11, it is possible to improve the dripping properties of the liquid agent discharged from the discharge port 11e.

From the viewpoint of improving the fluidity of the liquid agent, the amplitude of the high-frequency signal is preferably between 1% to 20% of the amplitude of the drive voltage signal, and the frequency of the high-frequency signal is preferably between 1 kHz to 30 kHz. In the case of a liquid agent exhibiting thixotropy, in general, as the frequency of the high-frequency signal increases, the fluidity can be improved.

From the viewpoint of improving the dripping properties, the amplitude of the high-frequency signal is preferably between 1% to 20% of the amplitude of the drive voltage signal, the frequency of the high-frequency signal is preferably between 1 kHz to 5 kHz.

In FIG. 3, the form in which the oscillating piezoelectric element 22 is disposed between the fixing member 14 and the horn 21 is exemplified, but the present invention is not limited to this. The oscillating piezoelectric element 22 may be disposed between the driving piezoelectric element 20 and the horn 21, or may be disposed between the diaphragm 12 and the driving piezoelectric element 20.

In FIG. 3, the form in which the driving piezoelectric element 20 and the horn 21 are sequentially arranged from the diaphragm 12 side is exemplified. As explained in the second embodiment, the arrangement of the driving piezoelectric element 20 and the horn 21 may be reversed.

### <Fourth Embodiment>

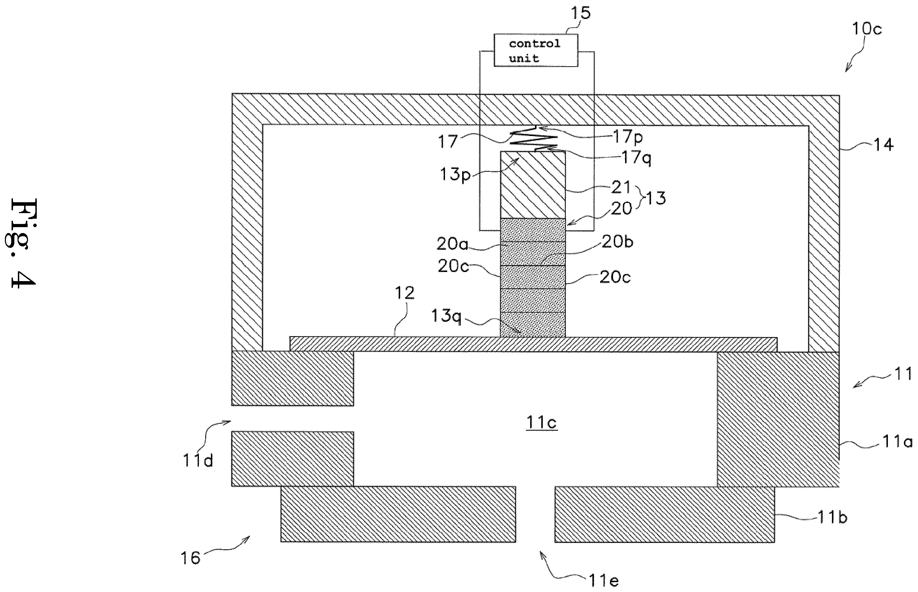

FIG. 4 is a schematic diagram showing a configuration of a liquid agent application device 10c according to the fourth embodiment. The difference between the liquid agent application device 10 according to the first embodiment and the liquid agent application device 10c according to the fourth embodiment is that a preload spring 17 is disposed between the drive unit 13 and the fixing member 14. Therefore, the difference will be mainly described below.

The preload spring 17 is located on the drive unit 13. The preload spring 17 is disposed between the drive unit 13 and the fixing member 14. The preload spring 17 is sandwiched between the drive unit 13 and the fixing member 14.

A first end portion 17p, of the preload spring 17, opposite to the drive unit 13 is connected to the fixing member 14. That is, the first end portion 17p of the preload spring 17 is fixed to the fixing member 14. Accordingly, the first end portion 17p of the preload spring 17 is a fixed end portion. The first end portion 17p of the preload spring 17 may be directly fastened to the fixing member 14, or, for example, may be connected to the fixing member 14 via an adhesive such as an epoxy resin.

A second end portion 17q, of the preload spring 17, toward the drive unit 13 is connected to the first end portion 13p of the drive unit 13. That is, the second end portion 17q of the preload spring 17 is fixed to the first end portion 13p of the drive unit 13. Therefore, in the present embodiment, the first end portion 13p of the drive unit 13 is not a fixed end portion. The second end portion 17q of the preload spring 17 may be directly fastened to the drive unit 13, or, for example, may be connected to the drive unit 13 via an adhesive such as an epoxy resin.

In FIG. 4, the case where a coil spring is used as the preload spring 17 is illustrated, but the present invention is not limited to this. Examples of the preload spring 17 may include known springs such as a disc spring, a leaf spring, or a spiral spring. The spring constant of the preload spring 17 is preferably larger than the spring constant of the diaphragm 12.

The preload spring 17 presses the drive unit 13 against the diaphragm 12. The preload spring 17 constantly presses the drive unit 13 against the diaphragm 12 regardless of whether the driving piezoelectric element 20 is expanded or contracted.

Here, since the second end portion 13q of the drive unit 13 is only in contact with the diaphragm 12, when the expanded driving piezoelectric element 20 contracts, not only a tensile force due to expansion occurs inside the driving piezoelectric element 20, but also ringing of the drive unit 13 itself may occur. However, in this embodiment, as mentioned above, the drive unit 13 can be pressed against the diaphragm 12 by the pressing force of the preload spring 17. For this reason, while suppressing the tensile force generated in the driving piezoelectric element 20, ringing of the drive unit 13 can be suppressed.

Also, when the second end portion 13q of the drive unit 13 is connected to the diaphragm 12, in a case where the expanded driving piezoelectric element 20 contracts, the contraction speed of the drive unit 13 is faster than the return speed of the diaphragm 12, so that there is a possibility that the drive unit 13 may be separated from the diaphragm 12. However, as in this embodiment, the drive unit 13 is pressed against the diaphragm 12 by the pressing force of the preload spring 17, so that the drive unit 13 can be prevented from being separate from the diaphragm 12.

### (Other embodiments)

Although the present invention has been described according to the above embodiments, the discussion and drawings that form part of this disclosure should not be construed as limiting the invention. From this disclosure, various alternative embodiments, examples and operational techniques will be apparent to those skilled in the art.

In the first to third embodiments, the first end portion 13p of the drive unit 13 is connected to the fixing member 14, but it may be only in contact with the fixing member 14.

In the first to fourth embodiments, the second end portion 13q of the drive unit 13 is in contact with the diaphragm 12, but it may be connected to the diaphragm 12.

In the first to fourth embodiments, the second end portion 13q of the drive unit 13 is in direct contact with the diaphragm 12, but an intermediate member that is in surface contact with the drive unit 13, and which is in point contact with the diaphragm 12 may be sandwiched between the second end portion 13q and the diaphragm 12. The intermediate member is fixed to the second end portion 13q of the drive unit 13, and can be brought into and out of contact with the diaphragm 12. Since it is possible to prevent the pressing force from being concentrated on part of the second end portion 13q of the drive unit 13 by sandwiching such an intermediate member, damage to the drive unit 13 can be suppressed.

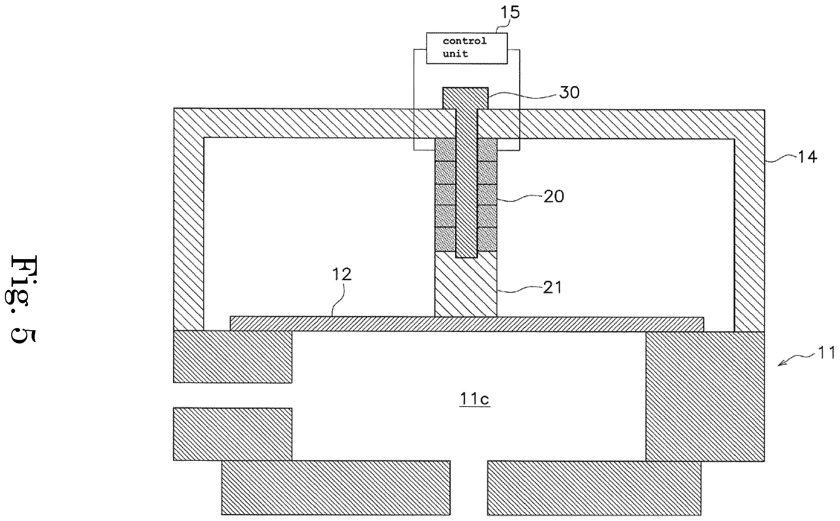

In the second embodiment, the driving piezoelectric element 20 is connected to the fixing member 14 and the horn 21, but as shown in FIG. 5, may be fixed between the fixing member 14 and the horn 21 through a fastener 30. Example of the fastener 30 may include a screw and the like. The fastener 30 passes through the driving piezoelectric element 20 and is fastened to the horn 21. In order to efficiently transmit the vibration of the driving piezoelectric element 20 to the horn 21, the fastener 30 preferably has a sufficient fastening force. The driving piezoelectric element 20 is formed in a shape (for example, a hollow ring shape) that allows the fastener 30 to pass therethrough. The end portion, of the driving piezoelectric element 20, toward the fixing member 14 is a fixed end portion. In this way, the vibration of the driving piezoelectric element 20 can be efficiently transmitted to the horn 21 by fixing the driving piezoelectric element 20 between the fixing member 14 and the horn 21 through the fastener 30, compared to, for example, the case where the both are connected via an elastic body such as an adhesive.

### REFERENCE SIGNS LIST

- 10: liquid agent application device
- 11: liquid agent reservoir
- 11a: housing
- 11b: nozzle
- 11c: pressure chamber
- 11d: liquid agent supply port
- 11e: discharge port
- 12: diaphragm
- 13: drive unit
- 14: fixing member
- 15: control unit
- 16: head
- 17: preload spring
- 20: driving piezoelectric element
- 21: horn
- 22: oscillating piezoelectric element

## Claims

1. A liquid agent application device comprising:
a liquid agent reservoir having a liquid agent discharge port;
a diaphragm that changes an internal volume of the liquid agent reservoir; and
a drive unit located on the diaphragm,
wherein the drive unit includes a driving piezoelectric element that vibrates in response to application of a drive voltage signal and a horn that vibrates together with the driving piezoelectric element.

2. The liquid agent application device according to claim 1, wherein the horn is connected to the driving piezoelectric element.

3. The liquid agent application device according to claim 1 or 2, wherein the driving piezoelectric element is disposed between the horn and the diaphragm.

4. The liquid agent application device according to claim 3, wherein the driving piezoelectric element is in contact with the diaphragm.

5. The liquid agent application device according to claim 1 or 2, wherein the horn is disposed between the driving piezoelectric element and the diaphragm.

6. The liquid agent application device according to claim 5, wherein the horn is in contact with the diaphragm.

7. The liquid agent application device according to any one of claims 1 to 6, wherein an end portion of the drive unit is a fixed end portion, the end portion being opposite to the diaphragm.

8. The liquid agent application device according to any one of claims 1 to 7, wherein the horn is fastened to the oscillating piezoelectric element.

9. The liquid agent application device according to any one of claims 1 to 8, wherein a natural vibration frequency of the horn is equal to or lower than a drive critical frequency of the driving piezoelectric element.

10. The liquid agent application device according to claim 9, wherein the natural vibration frequency of the horn is equal to a frequency of the drive voltage signal.

11. The liquid agent application device according to any one of claims 1 to 10, wherein the drive unit further includes an oscillating piezoelectric element that vibrates in response to application of a high-frequency signal having a frequency higher than a frequency of a drive voltage signal applied to the driving piezoelectric element.

12. The liquid agent application device according to any one of claims 1 to 11, further comprising a preload spring disposed opposite to the diaphragm of the drive unit, wherein an end portion of the spring is a fixed end portion, the end portion being opposite to the drive unit.

13. The liquid agent application device according to any one of claims 1 to 12, further comprising an intermediate member disposed between the drive unit and the diaphragm, wherein the intermediate member is in surface contact with the drive unit and is in point contact with the diaphragm.
